# EUROPEAN PATENT APPLICATION

(11) **EP 4 495 978 A1**
(43) Date of publication of application: **22.01.2025**
(21) Application number: 23186019.8
(22) Date of filing: 18.07.2023
(51) Int. Cl.: H01L 21/285, H01L 21/768, H01L 29/417, H01L 23/528

(54) **SEMICONDUCTOR DEVICE AND METHOD OF MANUFACTURING THE SAME**

(71) Applicant: Huawei Technologies Co., Ltd., Shenzhen, Guangdong 518129 (CN)
(72) Inventor: Schuddinck, Pieter, 3001 Leuven (BE); Bhuwalka, Krishna Kumar, 80992 Munich (DE); Hiblot, Gaspard, 3001 Leuven (BE)
(74) Representative: Pfenning, Meinig & Partner mbB

(57) **Abstract**

In some examples, a method of manufacturing a backside contact comprises providing an epitaxial structure on a planar substrate, wherein the epitaxial structure comprises a first part adjacent to a first surface of the planar substrate, a body portion, and a second part separated from the first part by the body portion such that the second part and the body portion are exposed above the first surface of the planar substrate, depositing a metal on the second part and the body portion of the epitaxial structure, whereby to form a first reacted metal layer on the second part and the body portion of the epitaxial structure, selectively removing unreacted metal from at least a portion of the first surface of the planar substrate, selectively removing a portion of the substrate on a second surface of the planar substrate to expose the first part of the epitaxial structure, wherein the second surface of the planar substrate is opposite to the first surface of the planar substrate, depositing a metal on the first part of the epitaxial structure, whereby to form a second reacted metal layer on the first part of the epitaxial structure, wherein the first reacted metal layer and the second reacted metal layer form a continuous reacted metal layer around the epitaxial structure, selectively removing unreacted metal from at least a portion of the second surface of the planar substrate, and forming the backside contact on a portion of the second reacted metal layer.

## Description

### TECHNICAL FIELD

The present disclosure relates, in general, to a semiconductor device and a method of manufacturing the same.

### BACKGROUND

In order to ensure the operation of an integrated circuit, power must be supplied and distributed as required. As semiconductor scaling becomes more and more developed, resulting in smaller and more densely packed circuits, power routing and design complexity remain critical challenges.

One approach dealing with these challenges is to introduce a backside interconnect structure to deliver power through the substrate to the front side of the integrated circuit. The backside interconnect structure employs a power distribution circuit, formed on the backside of the substrate, and a series of deep vias through the substrate to couple the power planes to front side metal lines.

Current backside contact schemes suffer from high capacitance to the gate, as well as high resistance due to a small silicide area, resulting in worsened performance.

### SUMMARY

An objective of the present disclosure is to provide a semiconductor device having an improved performance, as well as to provide a method of manufacturing such improved device.

The foregoing and other objectives are achieved by the features of the independent claims.

Further implementation forms are apparent from the dependent claims, the description and the Figures.

A first aspect of the present disclosure provides a method of manufacturing a backside contact, the method comprising providing an epitaxial structure on a planar substrate, wherein the epitaxial structure comprises a first part adj acent to a first surface of the planar substrate, a body portion, and a second part separated from the first part by the body portion such that the second part and the body portion are exposed above the first surface of the planar substrate, depositing a metal on the second part and the body portion of the epitaxial structure, whereby to form a first reacted metal layer on the second part and the body portion of the epitaxial structure, selectively removing unreacted metal from at least a portion of the first surface of the planar substrate, selectively removing a portion of the substrate on a second surface of the planar substrate to expose the first part of the epitaxial structure, wherein the second surface of the planar substrate is opposite to the first surface of the planar substrate, depositing a metal on the first part of the epitaxial structure, whereby to form a second reacted metal layer on the first part of the epitaxial structure, wherein the first reacted metal layer and the second reacted metal layer form a continuous reacted metal layer around the epitaxial structure, selectively removing unreacted metal from at least a portion of the second surface of the planar substrate, and forming the backside contact on a portion of the second reacted metal layer.

Accordingly, a device manufactured according to the above method benefits from reduced capacitance (due to the fact that a top contact metal is not present) and a reduced resistance to the gate (due to the fact that a junction is fully wrapped around with a reacted metal, such as silicide). The backside silicidation process merges with the frontside silicide, achieving a metal contact between the frontside silicide and the backside silicide.

In an implementation of the first aspect, the reacted metal layer may comprise silicide and/or germanide.

Selectively removing the portion of the substrate on the second surface of the planar substrate and selectively removing unreacted metal from at least the portion of the second surface of the planar substrate may comprise selectively etching away the portion of the substrate on the second surface of the planar substrate and unreacted metal, respectively.

The method may further comprise forming a top contact on the first reacted silicide layer.

The method may further comprise forming a bottom-dielectric isolation layer and/or pre-dielectric metallisation layer for the first part of the epitaxial structure.

The method may further comprise creating a recess in the first part of the epitaxial structure.

The method may further comprise forming a backside contact on the first part of the epitaxial structure.

A second aspect of the present disclosure provides a semiconductor device, comprising a planar substrate comprising a first surface and a second surface, wherein the second surface is opposite the first surface, a gate electrode on the first surface of the planar substrate, a backside contact arranged on a portion of the second surface, the backside contact arranged to connect to a power distribution network for the semiconductor device, at least one epitaxial structure on the first surface of the planar substrate, wherein the at least one epitaxial structure comprises a first part adjacent to the first surface of the planar substrate, a body portion, and a second part separated from the first part by the body portion such that the second part and the body portion of the at least one epitaxial structure are exposed above the first surface of the planar substrate, wherein the second part of the at least one epitaxial structure and the body portion of the at least one epitaxial structure comprise a first reacted metal layer and the first part of the at least one epitaxial structure comprises a second reacted metal layer, wherein the first reacted metal layer and the second reacted metal layer form a continuous reacted metal layer around the at least one epitaxial structure, wherein the continuous reacted metal layer around the at least one epitaxial structure is arranged to electrically connect the power distribution network to the gate electrode.

In an implementation of the second aspect, the device may further comprise a source region and a drain region.

The device may further comprise a plurality of channels arranged across the gate electrode, the channels arranged in parallel to the first and the second surface of the planar structure.

The channels may comprise a plurality of nanosheets.

The device may further comprise a plurality of spacers arranged to electrically isolate the gate electrode from the source region and the drain region, respectively.

The at least one epitaxial structure may comprise silicon, and/or the reacted metal layer may comprise silicide and/or germanide.

The semiconductor device may comprise a nanosheet field-effect transistor, FET.

The device may further comprise a single contact trench only.

These and other aspects of the invention will be apparent from the embodiment(s) described below.

### BRIEF DESCRIPTION OF THE DRAWINGS

In order that the present invention may be more readily understood, embodiments of the invention will now be described, by way of example, with reference to the accompanying drawings, in which:
Figure 1 is a schematic representation of a semiconductor device according to an example;
Figure 2 is a flow chart of a method of manufacturing a backside contact; and
Figures 3a-3k schematically depict a semiconductor device according to an example at various stages of manufacturing.

### DETAILED DESCRIPTION

Example embodiments are described below in sufficient detail to enable those of ordinary skill in the art to embody and implement the systems and processes herein described. It is important to understand that embodiments can be provided in many alternate forms and should not be construed as limited to the examples set forth herein.

Accordingly, while embodiments can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

The terminology used herein to describe embodiments is not intended to limit the scope. The articles "a," "an," and "the" are singular in that they have a single referent, however the use of the singular form in the present document should not preclude the presence of more than one referent. In other words, elements referred to in the singular can number one or more, unless the context clearly indicates otherwise. It will be further understood that the terms "comprises," "comprising," "includes," and/or "including," when used herein, specify the presence of stated features, items, steps, operations, elements, and/or components, but do not preclude the presence or addition of one or more other features, items, steps, operations, elements, components, and/or groups thereof.

Unless otherwise defined, all terms (including technical and scientific terms) used herein are to be interpreted as is customary in the art. It will be further understood that terms in common usage should also be interpreted as is customary in the relevant art and not in an idealized or overly formal sense unless expressly so defined herein.

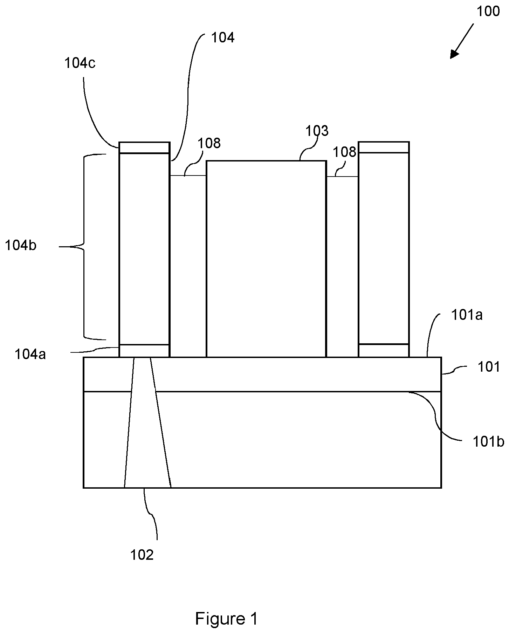

Figure 1 is a schematic representation of a semiconductor device according to an example. The semiconductor device 100 comprises a planar substrate 101, comprising a first surface 101a and a second surface 101b. The second surface 101b is opposite the first surface 101a. In an example, the second surface 101b may be located at a bottom of the planar substrate 101, and the first surface 101a may be located at a top of the planar substrate 101. The semiconductor device 100 comprises a backside contact 102 arranged on a portion of the second surface 101b of the planar substrate 101. In an example, the backside contact 102 may be located at the bottom of the planar substrate 101. The backside contact 102 is arranged to connect to a power distribution network for the semiconductor device 100. The semiconductor device 100 may comprise a transistor, such as a field-effect transistor (FET), or a complementary field-effect transistor (CFET).

The semiconductor device 100 comprises a gate electrode 103 on the first surface 101a of the planar substrate 101. In other words, the gate electrode 103 may extend from, extend out from, or grow from, the top surface of the planar substrate 101. The semiconductor device 100 comprises at least one epitaxial structure 104 on the first surface 101a of the planar substrate 101. In the example shown in Figure 1, the semiconductor device 100 comprises two epitaxial structures 104. The semiconductor device 100 may further comprise a spacer 108 to separate the gate electrode 103 from the surrounding structures such as the epitaxial structure 104.

The epitaxial structure 104 may comprise a source/drain region. The term "source/drain region" may refer to the part of the epitaxial structure 104 in which the corresponding terminals of a transistor may be formed. In an example, the semiconductor device 100 may further comprise a channel region arranged between a plurality of epitaxial structures 104, with a first epitaxial structure 104 comprising a source region, and a second epitaxial structure 104 comprising a drain region. The channel region may be controlled by the gate electrode 103. During operation of the semiconductor device 100, the gate electrode 103 may be used for controlling the flow of electrical carriers between the plurality of epitaxial structures 104. The source/drain and channel of the transistor, which may be formed by parts of the material of the source/drain region and the channel region of the semiconductor device structure, may be connected to electrical contacting or connecting structures. The electrical contacting structure coupled to the channel may be referred to as a gate or a gate contact, and may be used for modulating the channel conductivity.

In an example, the semiconductor device 100 may comprise a plurality of channels arranged across the gate electrode 104, i.e. in parallel to the first/second surfaces 101a and 101b of the planar substrate 101, and perpendicular to the at least one epitaxial structure 104. The plurality of channels may comprise nanosheets. That is, the semiconductor device 100 may comprise a nanosheet field-effect transistor (FET). The plurality of channels may be arranged between the plurality of epitaxial structures 104. The semiconductor device 100 may comprise a plurality of spacers arranged to electrically isolate the gate electrode 103 from the source region and the drain region of the plurality of epitaxial structures 104.

The at least one epitaxial structure 104 comprises a first part 104a adjacent to the first surface 101a of the planar substrate 101, a body portion 104b, and a second part 104c. The planar substrate 101 may comprise, for example, a semiconductor substrate such as a silicon substrate. The planar substrate 101 may comprise, additionally or alternatively, a germanium substrate, a SiGeOI substrate, a SiC substrate, a SOI substrate, or a GeOI substrate.

The second part 104c is separated from the first part 104a by the body portion 104b, such that the second part 104c and the body portion 104b are exposed above the first surface 101a of the planar substrate 101. The body portion 104b may be arranged between the first part 104a and the second part 104c. In another example, the first part 104a may be arranged directly on the first surface 101a (e.g., the top surface of) the planar substrate 101, such that it protrudes from the first surface 101a, therefore also being exposed above the first surface 101a. The body portion 104b and the second part 104c may be arranged on top of the first part 104a. Alternatively, the second part 104c, arranged on top of the first part 104a, may comprise the body portion 104b, such that the first part 104a and the second part 104c share a common boundary.

The second part 104c of the at least one epitaxial structure 104 and the body portion 104b of the at least one epitaxial structure 104 comprise a first reacted metal layer and the first part 104a of the at least one epitaxial structure 104 comprises a second reacted metal layer, wherein the first reacted metal layer and the second reacted metal layer form a continuous reacted metal layer around the at least one epitaxial structure 104. The continuous reacted metal layer around the at least one epitaxial structure 104 is arranged to electrically connect the power distribution network to the gate electrode 103.

The first reacted metal layer and the second reacted metal layer may cover not only the outer surfaces of the at least one epitaxial structure 104, but also all material within the epitaxial structure 104, i.e. extending through the entire width of the epitaxial structure 104. The first reacted metal layer and the second reacted metal layer may not cover the entire surface of the at least one epitaxial structure 104, instead covering a surface portion that defines a contact area sufficiently large to provide a proper, functional contacting of the epitaxial structure 104 of the semiconductor device 100.

The first reacted metal layer and the second reacted metal layer may comprise a metal (for example, titanium, cobalt, and/or a nickel-platinum alloy) processed/reacted to become a reacted metal, the details of the process will be described in more detail further in the specification. The first reacted metal layer and the second reacted metal layer may comprise the same reacted metal, or different reacted metals. In an example, the reacted metal may comprise at least one of silicide and germanide. The at least one epitaxial structure 104 may comprise silicon.

Advantageously, in an example where the semiconductor device 100 comprises two epitaxial structures 104, a single contact trench (arranged on the second part 104c of the epitaxial structure 104) may be required, rather than requiring the provision of two contact trenches (one on top of each epitaxial structure). This allows for parasitic capacitance to be reduced. In an embodiment, the device 100 may comprise multiple contact trenches. The disclosed technology allows the power to be delivered from below, without having to go through a routing structure connecting the top part of the semiconductor from the top. This advantage is achieved by providing the continuous reacted metal layer around the at least one epitaxial structure 104. In turn, this allows for a more densely packed circuit, as the space otherwise used for the vertical routing between a backside interconnect structure and the top of the semiconductor can be saved. In addition, the direct connection from the bottom of the semiconductor eliminates the resistance and parasitic capacitance associated with routing to the top of the semiconductor.

Electrically connecting the semiconductor from below benefits from the continuous reacted metal layer on the top and bottom portions of the source/drain region. The bottom portion of the source/drain region may form a landing pad for backside connections and may be used to bias the source/drain region, while the top portion of the source/drain region provides a large contact area and thus reduces interface resistance.

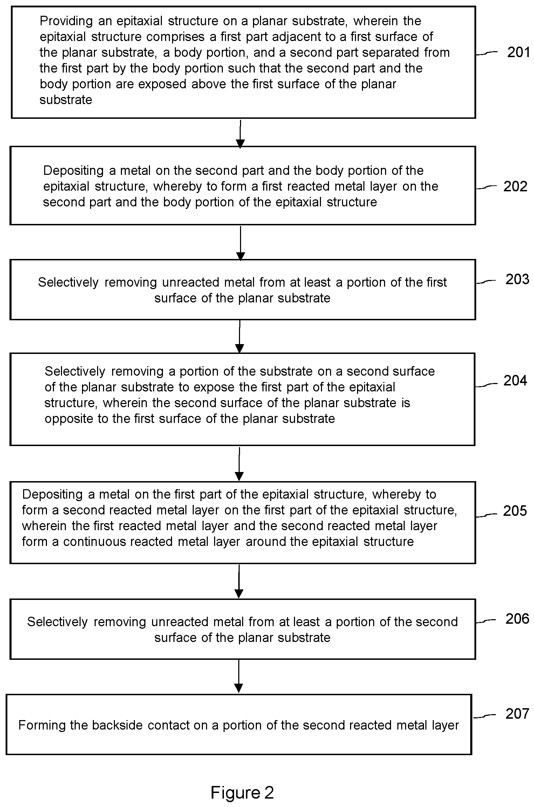

Figure 2 is a flow chart of a method of manufacturing a backside contact. The backside contact may be manufactured for/in a semiconductor device, such as the semiconductor device 100 described above. The method comprises, in step 201, providing an epitaxial structure on a planar substrate. The epitaxial structure comprises a first part adjacent to a first surface of the planar substrate, a body portion, and a second part separated from the first part by the body portion such that the second part and the body portion are exposed above the first surface of the planar substrate. As mentioned above, the epitaxial structure may be, for example, the at least one epitaxial structure 104 of Figure 1.

In step 202, the method comprises depositing a metal on the second part and the body portion of the epitaxial structure, whereby to form a first reacted metal layer on the second part and the body portion of the epitaxial structure. In particular, the method may comprise depositing a metal - for example, titanium, cobalt, and/or a nickel-platinum alloy - and processing it thermally (e.g., annealing), resulting in a reacted metal. The method may also comprise depositing silicon on the second part and the body portion of the epitaxial structure. The reacted metal may comprise silicide and/or germanide. In step 203, the method comprises selectively removing unreacted metal from at least a portion of the first surface of the planar substrate. Here, "unreacted metal" refers to a metal layer that does not comprise reacted metal, e.g., metal that was not subject to thermal processing. The unreacted metal may be removed so as to avoid short circuits between different reacted portions.

In step 204, the method comprises selectively removing a portion of the substrate on a second surface of the planar substrate to expose the first part of the epitaxial structure, wherein the second surface of the planar substrate is opposite to the first surface of the planar substrate. As discussed above in relation to Figure 1, the first surface of the planar substrate may be a top surface, and the second surface of the planar substrate may be a bottom surface. Step 204 may further comprise selectively etching away the portion of the substrate on the second surface of the planar substrate.

In step 205, the method comprises depositing a metal on the first part of the epitaxial structure, whereby to form a second reacted metal layer on the first part of the epitaxial structure, wherein the first reacted metal layer and the second reacted metal layer form a continuous reacted metal layer around the epitaxial structure. The metal deposited on the first part of the epitaxial structure may be the same type of metal that was deposited on the second part of the epitaxial structure and the body portion, but the invention is not limited thereto. In another example, a different metal may be deposited on the first part, compared to the second part and the body part. In addition to the metal, other elements may also be deposited, for example, silicon.

In step 206, the method comprises selectively removing unreacted metal from at least a portion of the second surface of the planar substrate. This may be achieved by selectively etching away unreacted metal.

In step 207, the method comprises forming the backside contact on a portion of the second reacted metal layer. As discussed above, providing the continuous reacted metal layer around the epitaxial structure allows the power to be delivered from below, without having to go through a routing structure connecting the top part of the device from the top.

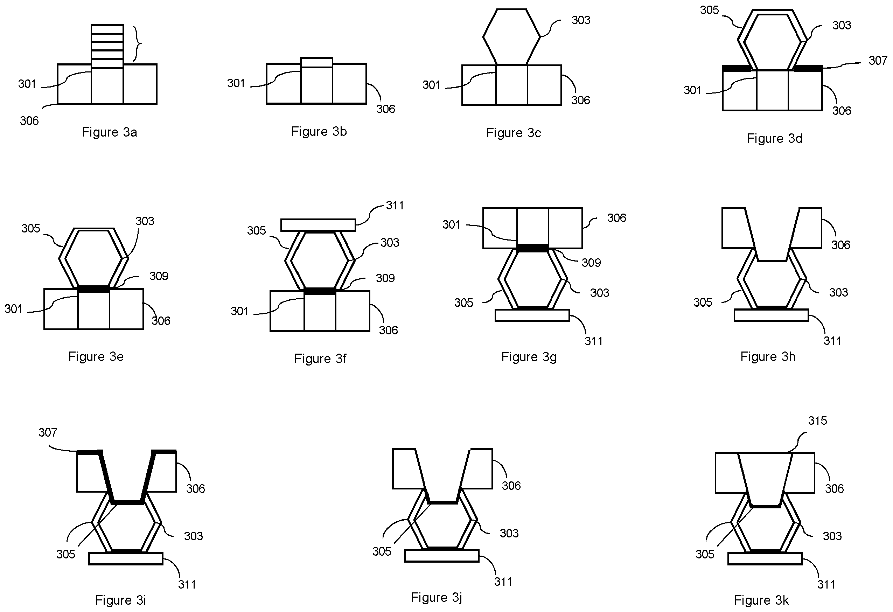

Figures 3a-3k schematically depict a semiconductor device according to an example at various stages of manufacturing. The resulting semiconductor device may be the semiconductor device 100 described above, and the process may be the same as the process of Figure 2. In these figures, it is assumed that the side from which the grown epitaxy region extends from is the frontside of the wafer.

Figure 3a shows the growth of an epitaxial stack, for example, a Silicon/Silicon-Germanium (Si/SiGe, 301/302) stack. This stack may comprise channel and sacrificial layers of the semiconductor device. In Figure 3b, a junction recess is created by removing the Si/SiGe 202 in the place where the source/drain epitaxy may be formed. Figure 3c depicts N-type doped silicon selective epitaxy 303 (in case the semiconductor device comprises an n-channel field-effect transistor, nFET) or a p-type doped Si/SiGe selective epitaxy 303 (in case the semiconductor device comprises a p-channel field-effect transistor, pFET).

In Figure 3d, a metal layer is deposited on the grown epitaxy region 303. The metal layer may comprise the same metal for both pFETs and nFETs, or different metals for each type. The metal layer may comprise, for example, titanium, cobalt, and/or a nickel-platinum alloy. The deposited metal layer is reacted to form a first reacted metal layer 305. In order to form the first reacted metal layer 305, the metal layer deposited on the grown epitaxy region 303 may be annealed or otherwise thermally processed. The metal layer which has not been reacted - for example, metal deposited on a substrate 306 instead, shown in Figure 3d- may be selectively etched away. The unreacted metal may be removed so as to avoid short circuits between different reacted portions.

Figure 3e depicts further processing done to the semiconductor device. For example, a bottom-dielectric isolation 309 may be formed, and/or pre-dielectric metallisation may be performed. In Figure 3f, a top contact 311 may be formed on the front side of the grown epitaxy region 303, in connection to silicide on the front side. Referring back to Figure 1, the top contact may be form on the second part 104c of the at least one epitaxial structure 104. Then, the wafer may be flipped to enable easier backside processing of the semiconductor device 100, as shown in Figure 3g. The silicon 301 and the dielectric 306 may be selectively removed below the epitaxy region 303. In Figure 3h, the epitaxy region 303 silicon may be further etched (timed and selective to the reacted metal layer 305) to enable a self-aligned process of forming a continuous reacted metal layer. This process also exposes low resistive regions in the epitaxy region, if needed. Figure 3i depicts depositing and reacting a metal layer to form a second reacted metal layer 307. Some of the deposited metal layer may not be reacted, thereby forming unreacted metal layer. The second reacted metal layer 307 merges with the first reacted metal layer 305 to form a continuous reacted metal layer around the semiconductor device. In other words, the top and bottom metal layers are connected. In Figure 3j, unreacted silicide is removed, similar to what was shown in Figure 3d. Finally, in Figure 3k, a backside contact may be formed.

The preceding description has been provided to enable others skilled in the art to best utilize various aspects of the exemplary embodiments disclosed herein. This exemplary description is not intended to be exhaustive or to be limited to any precise form disclosed. Many modifications and variations are possible without departing from the spirit and scope of the instant disclosure. The embodiments disclosed herein should be considered in all respects illustrative and not restrictive. Reference should be made to the appended claims and their equivalents in determining the scope of the instant disclosure.

## Claims

1. A method of manufacturing a backside contact, the method comprising:
providing an epitaxial structure on a planar substrate, wherein the epitaxial structure comprises a first part adjacent to a first surface of the planar substrate,
a body portion, and a second part separated from the first part by the body portion such that the second part and the body portion are exposed above the first surface of the planar substrate (201);
depositing a metal on the second part and the body portion of the epitaxial structure, whereby to form a first reacted metal layer on the second part and the body portion of the epitaxial structure (202);
selectively removing unreacted metal from at least a portion of the first surface of the planar substrate (203);
selectively removing a portion of the substrate on a second surface of the planar substrate to expose the first part of the epitaxial structure, wherein the second surface of the planar substrate is opposite to the first surface of the planar substrate (204);
depositing a metal on the first part of the epitaxial structure, whereby to form a second reacted metal layer on the first part of the epitaxial structure, wherein the first reacted metal layer and the second reacted metal layer form a continuous reacted metal layer around the epitaxial structure (205);
selectively removing unreacted metal from at least a portion of the second surface of the planar substrate (206); and
forming the backside contact on a portion of the second reacted metal layer (207).

2. The method of claim 1, wherein the reacted metal layer (305, 307) comprises silicide and/or germanide.

3. The method of claim 1 or 2, wherein selectively removing the portion of the substrate on the second surface of the planar substrate (204) and selectively removing unreacted metal from at least the portion of the second surface of the planar substrate (206) comprises selectively etching away the portion of the substrate on the second surface of the planar substrate and unreacted metal, respectively.

4. The method of claim 1, 2 or 3, further comprising forming a top contact (311) on the first reacted silicide layer.

5. The method of any one of claims 1 to 4, further comprising forming a bottom-dielectric isolation layer (309) and/or pre-dielectric metallisation layer for the first part of the epitaxial structure.

6. The method of any preceding claim, further comprising creating a recess in the first part of the epitaxial structure.

7. The method of any preceding claim, further comprising forming a backside contact (315) on the first part of the epitaxial structure.

8. A semiconductor device (100), comprising:
a planar substrate (101) comprising a first surface (101a) and a second surface (101b), wherein the second surface (101b) is opposite the first surface (101a);
a gate electrode (103) on the first surface (101a) of the planar substrate (101);
a backside contact (102) arranged on a portion of the second surface (101b), the backside contact (102) arranged to connect to a power distribution network for the semiconductor device (100);
at least one epitaxial structure (104) on the first surface (101a) of the planar substrate (101), wherein the at least one epitaxial structure (104) comprises a first part (104a) adjacent to the first surface (101a) of the planar substrate (100),
a body portion (104b), and a second part (104c) separated from the first part (104a) by the body portion (104b) such that the second part (104c) and the body portion (104b) of the at least one epitaxial structure (104) are exposed above the first surface (101a) of the planar substrate (101),
wherein the second part (104c) of the at least one epitaxial structure (104) and the body portion (104b) of the at least one epitaxial structure (104) comprise a first reacted metal layer and the first part (104a) of the at least one epitaxial structure (104) comprises a second reacted metal layer, wherein the first reacted metal layer and the second reacted metal layer form a continuous reacted metal layer around the at least one epitaxial structure (104),
wherein the continuous reacted metal layer around the at least one epitaxial structure (104) is arranged to electrically connect the power distribution network to the gate electrode (103).

9. The semiconductor device (100) of claim 8, further comprising a source region and a drain region.

10. The semiconductor device (100) of claim 9, further comprising a plurality of channels arranged across the gate electrode (103), the channels arranged in parallel to the first (101a) and the second surface (101b) of the planar structure (101).

11. The semiconductor device (100) of claim 10, wherein the channels comprise a plurality of nanosheets.

12. The semiconductor device (100) of claim 10 or 11, further comprising a plurality of spacers (108) arranged to electrically isolate the gate electrode (103) from the source region and the drain region, respectively.

13. The semiconductor device (100) of any preceding claim, wherein the at least one epitaxial structure (104) comprises silicon, and/or the reacted metal layer comprises silicide and/or germanide.

14. The semiconductor device (100) of any preceding claim, wherein the semiconductor device (100) comprises a nanosheet field-effect transistor, FET.

15. The semiconductor device (100) of any preceding claim, comprising a single contact trench only.

## Amended claims

### Amended claims in accordance with Rule 137(2) EPC.

1. A method of manufacturing a backside contact, the method comprising:
providing an epitaxial structure on a planar substrate, wherein the epitaxial structure comprises a first part adjacent to a first surface of the planar substrate,
a body portion, and a second part separated from the first part by the body portion such that the second part and the body portion are exposed above the first surface of the planar substrate (201);
depositing a metal on the second part and the body portion of the epitaxial structure, whereby to form a first reacted metal layer on the second part and the body portion of the epitaxial structure (202);
selectively removing unreacted metal from at least a portion of the first surface of the planar substrate (203);
selectively removing a portion of the substrate on a second surface of the planar substrate to expose the first part of the epitaxial structure, wherein the second surface of the planar substrate is opposite to the first surface of the planar substrate (204);
depositing a metal on the first part of the epitaxial structure, whereby to form a second reacted metal layer on the first part of the epitaxial structure, wherein the first reacted metal layer and the second reacted metal layer form a continuous reacted metal layer around the epitaxial structure (205);
selectively removing unreacted metal from at least a portion of the second surface of the planar substrate (206);
forming the backside contact on a portion of the second reacted metal layer (207); and
forming a gate electrode (103);
**characterized in that**
the gate electrode (103) is formed on the first surface (101a) of the planar substrate (101); and
the continuous reacted metal layer around the epitaxial structure (104) is arranged to electrically connect a power distribution network to the gate electrode (103).

2. The method of claim 1, wherein the reacted metal layer (305, 307) comprises silicide and/or germanide.

3. The method of claim 1 or 2, wherein selectively removing the portion of the substrate on the second surface of the planar substrate (204) and selectively removing unreacted metal from at least the portion of the second surface of the planar substrate (206) comprises selectively etching away the portion of the substrate on the second surface of the planar substrate and unreacted metal, respectively.

4. The method of claim 1, 2 or 3, further comprising forming a top contact (311) on the second part.

5. The method of any preceding claim, further comprising creating a recess in the first part of the epitaxial structure.

6. A semiconductor device (100), comprising:
a planar substrate (101) comprising a first surface (101a) and a second surface (101b), wherein the second surface (101b) is opposite the first surface (101a);
a gate electrode (103);
a backside contact (102) arranged on a portion of the second surface (101b), the backside contact (102) arranged to connect to a power distribution network for the semiconductor device (100);
at least one epitaxial structure (104) on the first surface (101a) of the planar substrate (101), wherein the at least one epitaxial structure (104) comprises a first part (104a) adjacent to the first surface (101a) of the planar substrate (100),
a body portion (104b), and a second part (104c) separated from the first part (104a) by the body portion (104b) such that the second part (104c) and the body portion (104b) of the at least one epitaxial structure (104) are exposed above the first surface (101a) of the planar substrate (101),
wherein the second part (104c) of the at least one epitaxial structure (104) and the body portion (104b) of the at least one epitaxial structure (104) comprise a first reacted metal layer and the first part (104a) of the at least one epitaxial structure (104) comprises a second reacted metal layer, wherein the first reacted metal layer and the second reacted metal layer form a continuous reacted metal layer around the at least one epitaxial structure (104),
**characterized in that**
the gate electrode (103) is provided on the first surface (101a) of the planar substrate (101), and
the continuous reacted metal layer around the at least one epitaxial structure (104) is arranged to electrically connect the power distribution network to the gate electrode (103).

7. The semiconductor device (100) of claim 6, further comprising a source region and a drain region.

8. The semiconductor device (100) of claim 7, further comprising a plurality of channels arranged across the gate electrode (103), the channels arranged in parallel to the first (101a) and the second surface (101b) of the planar structure (101).

9. The semiconductor device (100) of claim 8, wherein the channels comprise a plurality of nano sheets.

10. The semiconductor device (100) of claim 8 or 9, further comprising a plurality of spacers (108) arranged to electrically isolate the gate electrode (103) from the source region and the drain region, respectively.

11. The semiconductor device (100) of any one of claims 6 to 10, wherein the at least one epitaxial structure (104) comprises silicon, and/or the reacted metal layer comprises silicide and/or germanide.

12. The semiconductor device (100) of any one of claims 6 to 11, wherein the semiconductor device (100) comprises a nanosheet field-effect transistor, FET.

13. The semiconductor device (100) of any one of claims 6 to 12, comprising a single contact trench arranged on the second part (104c) of the at least one epitaxial structure (104) only.
